(19) Europäisches Patentamt / European Patent Office / Office européen des brevets

(11) **EP 2 291 911 B1**

(12) **FASCICULE DE BREVET EUROPEEN**

(45) Date de publication et mention
de la délivrance du brevet:
**28.11.2012 Bulletin 2012/48**

(21) Numéro de dépôt: **09769508.4**

(22) Date de dépôt: **29.05.2009**

(51) Int Cl.:
**H03H 9/17** *(2006.01)* **H03H 9/02** *(2006.01)*

(86) Numéro de dépôt international:
**PCT/FR2009/051023**

(87) Numéro de publication internationale:
**WO 2009/156667 (30.12.2009 Gazette 2009/53)**

(54) **RÉSONATEUR HBAR À INTÉGRATION ÉLEVÉE**

HBAR-RESONATOR MIT HOHEM INTEGRATIONSGRAD

HBAR RESONATOR WITH A HIGH LEVEL OF INTEGRATION

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **04.06.2008 FR 0853690**

(43) Date de publication de la demande:
**09.03.2011 Bulletin 2011/10**

(73) Titulaire: **Centre National de la Recherche Scientifique
(C.N.R.S)
75016 Paris (FR)**

(72) Inventeurs:
• **BALLANDRAS, Sylvain
F-25000 Besançon (FR)**
• **GACHON, Dorian
F-66750 Saint-Cyprien (FR)**

(74) Mandataire: **Domenego, Bertrand
Cabinet Lavoix
2, place d'Estienne d'Orves
75441 Paris Cedex 09 (FR)**

(56) Documents cités:
**US-A- 3 401 275**

• **MCAVOY B R ET AL: "Highly stable, ovenized bulk shear mode resonators" PROCEEDINGS OF THE ANNUAL FREQUENCY CONTROL SYMPOSIUM. PHILADELPHIA, MAY 29 - 31 1985. MAY 29 - 31, 1985; [PROCEEDINGS OF THE ANNUAL FREQUENCY CONTROL SYMPOSIUM], NEW YORK, IEEE, US, vol. SYMP. 39, 31 mai 1985 (1985-05-31), pages 372-374, XP008090791**
• **MASSON J ET AL: "High Overtone Bulk Acoustic Resonators built using Aluminum Nitride thin films deposited onto ATcut quartz plates" INTERNATIONAL FREQUENCY CONTROL SYMPOSIUM AND EXPOSITION, 2006 IEEE, IEEE, PI, 1 juin 2006 (2006-06-01), pages 835-838, XP031003812**
• **GACHON D ET AL: "P1H-1 LiNbO3-LiNbO3 High Overtone Bulk Acoustic Resonator Exhibiting High Q.f Product" ULTRASONICS SYMPOSIUM, 2007. IEEE, IEEE, PISCATAWAY, NJ, USA, 1 octobre 2007 (2007-10-01), pages 1417-1420, XP031195247**

**EP 2 291 911 B1**

# Description

L'invention se rapporte à un résonateur de type à ondes de volumes à modes harmoniques élevés (dénommé HBAR en anglais pour High Bulk Acoustic Resonator) stable en température ayant un niveau d'intégration élevé, à un procédé de fabrication correspondant, à un oscillateur et à un filtre comportant au moins à un tel résonateur.

Des résonateurs mécaniques, c'est-à-dire fabriqués par usinage mécanique de métal, à base de cavités électromagnétiques à vide délimitées par des parois métalliques, sont couramment utilisés pour la stabilisation en température des oscillateurs électriques, ainsi que pour de nombreuses applications de traitement de signal (filtrage à sélectivité élevée, détection en bande étroite, codage, etc.) à base de composants passifs dans la gamme de fréquences allant de 2 GHz à 20 GHz, en particulier dans le domaine des activités spatiales.

Ces dispositifs sont optimisés pour leurs applications particulières en cherchant à maximiser leurs coefficients de qualité ou de couplage par exemple.

Si le réglage de résonateurs mécaniques offrant un bon compromis entre fort couplage électrique, fort coefficient de qualité et stabilité thermique reste délicat, l'inconvénient majeur de tels dispositifs réside dans leur masse et leur encombrement élevés.

Les composants micro-ruban (dénommés microstrips en anglais) constituent une étape importante dans l'intégration des composants passifs utilisés pour le filtrage de bande dans la gamme de fréquence 2 GHz à 20 GHz, au prix de la maîtrise des dérives thermiques et à moindre qualité de la résonnance. Les composants sont réalisés par lithographie de pistes métalliques sur substrats diélectriques et permettent de ce fait une réduction notable de dimension. Néanmoins, ces objets restent dans des dimensions de plusieurs centimètres, même si celles-ci tendent à diminuer avec la montée en fréquence. Pour la gamme de fréquences 2 GHz à 20 GHz, elles restent toujours supérieures au centimètre.

Le problème technique est d'améliorer le niveau d'intégration en masse et volume de résonateurs électriques à fréquence élevée comprise dans la gamme de fréquences 2 à 20 GHz présentant une stabilité en température élevée.

A cet effet l'invention a pour objet un résonateur de type à ondes de volumes à modes harmoniques élevés HBAR destiné à travailler à une fréquence de travail prédéterminée comprenant :

un transducteur piézoélectrique constitué par une couche d'une première épaisseur d'un premier matériau orienté selon un angle φ défini par la nomenclature (YXw)/φ du standard IEEE Std-176 (révision 1949) égal à zéro, coupé selon un premier angle de coupe θ1 défini par la nomenclature (YXl)/θ du standard IEEE Std-176 (révision 1949), tel que le couplage électroacoustique des ondes de cisaillement au sein de ce matériau seul est supérieur à 5%, le transducteur ayant un coefficient de température de la fréquence CTFA fonction du premier angle de coupe θ1,

un substrat acoustique constitué par une couche d'une deuxième épaisseur d'un deuxième matériau ayant un produit coefficient de qualité acoustique fréquence de travail au moins égal à $5.10^{12}$ , orienté selon un angle φ défini par la nomenclature (YXw)/φ du standard IEEE Std-176 (révision 1949) égal à zéro, coupé selon un deuxième angle de coupe θ2 défini par la nomenclature (YXl)/θ du standard IEEE Std-176 (révision 1949), présentant au moins une direction de polarisation $\overline{P}_{B1}$ correspondant à un premier mode de vibration de cisaillement, le substrat acoustique ayant un coefficient de température de la fréquence du premier ordre CTFB1 correspondant à l'au moins un mode de cisaillement et dépendant du deuxième angle de coupe θ2,

une contre-électrode formé par une couche de métal collant une première face du transducteur et une face du substrat acoustique, et

une électrode disposée sur une deuxième face du transducteur opposée à la première face du transducteur et le substrat,

caractérisé en ce que

la disposition relative du transducteur et du substrat est telle que la direction de polarisation $\overline{P}_A$ du mode de cisaillement du transducteur et la direction de polarisation $\overline{P}_{B1}$ de l'au moins un mode de cisaillement du substrat correspondant au deuxième angle θ2 de coupe sont alignées, et

le deuxième angle de coupe θ2 du substrat est tel que le coefficient de température de la fréquence du premier ordre CTFB1 correspondant est un extrémum local en valeur absolue inférieur à 20 ppm.K$^{-1}$ et la variation de CTFB1 autour de cette valeur de θ2 est une variation douce inférieure en valeur absolue à 2 ppm.K$^{-1}$ /degré.

Suivant des modes particuliers de réalisation, le résonateur de type HBAR comporte l'une ou plusieurs des caractéristiques suivantes :

- le coefficient de température de la fréquence du premier ordre CTF1 du résonateur est égal sensiblement au coefficient de température de la fréquence du premier ordre CTFB1 pour des modes de résonateur HBAR ne correspondant ni au fondamental, ni aux harmoniques impaires de la résonance du transducteur seul lorsque le rapport Re de la première épaisseur sur la deuxième épaisseur est inférieur à 5% ;

- la valeur du coefficient en température de fréquence du premier ordre CTF1 du résonateur est égale au coefficient de température de la fréquence du premier ordre CTFB1 corrigé par un terme correctif additionnel pour des modes de résonateur HBAR ne correspondant ni au fondamental, ni aux harmoniques impaires de la résonance du transducteur seul lorsque le rapport Re de la première épaisseur sur la deuxième épaisseur est inférieur à 5%, le terme correctif s'écrivant $\alpha.n$ avec n le nombre entier désignant l'ordre harmonique du mode de résonance du résonateur et $\alpha$ un coefficient dépendant du rapport des épaisseurs Re décroissant en valeur absolue en fonction de Re ;

- le matériau du transducteur est compris dans l'ensemble des matériaux constitué par le nitrure d'aluminium (AIN), l'oxyde de zinc (ZnO), le niobate de lithium (LiNbO$_3$), le tantalate de lithium (LiTaO$_3$) et le niobate de potassium ;
- le matériau du transducteur est compris de préférence dans l'ensemble des matériaux constitué par le niobate de lithium (LiNbO$_3$ et le tantalate de lithium (LiTaO$_3$) ;
- le matériau du substrat acoustique est compris dans l'ensemble des matériaux constitué par le quartz, le niobate de potassium, l'orthophosphate de gallium (GaPO$_4$) le tétraborate de lithium (LiB$_4$O$_7$),la langasite (La$_3$Ga$_5$SiO$_{14}$), le langatate et la langanite ;
- le matériau du substrat acoustique est du quartz ;
- la contre-électrode est un métal thermocompressible ;
- la contre-électrode est constituée d'or ou de cuivre ou d'indium;
- les dimensions géométriques du résonateur sont adaptées pour une fréquence de résonnance d'une bande de fréquences comprise dans la gamme de fréquences allant de 50 MHz à 20 GHz ;
- le matériau du substrat acoustique est du quartz, le deuxième angle de coupe $\theta2$ du substrat est égal à -32 degrés, et
la direction de polarisation $\overline{P}_{B1}$ correspond au mode de cisaillement lent du quartz pour la valeur de $\theta2$ égale à -32 degrés ; et
- le matériau du transducteur est du niobate de potassium et le coefficient $\alpha$ est égal à respectivement $-3.10^{-7}$, $-1,5.10^{-7}$, $-3$, $75.10^{-8}$, $-1,875.10^{-8}$ pour un rapport des épaisseurs Re respectif égal à 5%, 2%, 1%, 0,5%.

L'invention a également pour objet un procédé de fabrication d'un résonateur HBAR comprenant les étapes consistant à :

fournir un transducteur piézoélectrique constitué par une couche d'une première épaisseur d'un premier matériau orienté selon un angle $\varphi$ défini par la nomenclature (YXw)/$\varphi$ du standard IEEE Std-176 (révision 1949) égal à zéro, coupé selon un premier angle de coupe $\theta1$ défini par la nomenclature (YXl) /$\theta$ du standard IEEE Std-176 (révision 1949), tel que le couplage électroacoustique des ondes de cisaillement au sein de ce matériau seul est supérieur à 5%, le transducteur ayant un coefficient de température de la fréquence CTFA fonction du premier angle de coupe $\theta1$, et
fournir un substrat acoustique constitué par une couche d'une deuxième épaisseur d'un deuxième matériau ayant un produit coefficient de qualité acoustique fréquence de travail au moins égal à $5.10^{12}$ , orienté selon un angle $\varphi$ défini par la nomenclature (YXw)/$\varphi$ du standard IEEE Std-176 (révision 1949) égal à zéro, coupé selon un deuxième angle coupe $\theta2$ défini par la nomenclature (YXl)/$\theta$ du standard IEEE Std-176 (révision 1949), présentant une direction de polarisation $\overline{P}_{B1}$ correspondant à un premier mode de vibration de cisaillement, le substrat acoustique ayant un coefficient de température de la fréquence du premier ordre CTFB1 correspondant à l'au moins un mode de cisaillement et dépendant du deuxième angle de coupe $\theta2$,
métalliser une face du substrat et une première face du transducteur par un métal thermo-compressible, assembler le transducteur et le substrat,
coller par compression les faces respectives du substrat et du transducteur métallisés à l'étape,
métalliser une électrode sur une deuxième face du transducteur,
caractérisé en ce que
pendant l'étape d'assemblage, le transducteur est disposé par rapport au substrat de sorte que la disposition relative du transducteur et du substrat est telle que la direction de polarisation $\overline{P}_A$ du mode de cisaillement du transducteur et la direction de polarisation $\overline{P}_{B1}$ de l'au moins un mode de cisaillement du substrat correspondant au deuxième angle $\theta2$ de coupe sont alignées, et
en ce que dans l'étape de fourniture du substrat, le deuxième angle de coupe $\theta2$ du substrat est choisi tel que le coefficient de température de la fréquence du premier ordre CTFB1 correspondant est un extremum local en valeur absolue inférieur à 20 ppm.K$^{-1}$ et la variation de CTFB1 autour de cette valeur de $\theta2$ est une variation douce inférieure en valeur absolue à 2 ppm.K$^{-1}$ /degré.

L'invention a également pour objet un oscillateur homodyne comprenant un résonateur HBAR tel que défini ci-dessus.

L'invention a également pour objet un filtre à réjection élevée comprenant des cellules à base de résonateurs HBAR tels que définis ci-dessus.

L'invention sera mieux comprise à la lecture de la description d'une forme de réalisation qui va suivre, donnée uniquement à titre d'exemple et faite en se référant aux dessins sur lesquels :

- la figure 1 est une vue en perspective d'un résonateur HBAR selon l'invention
- la figure 2 est une vue d'une coupe transversale du résonateur de la figure 2 selon la ligne II-II,
- la figure 3 est une vue de la représentation du premier angle de coupe $\theta1$ du cristal formant le transducteur piézoélectrique,

- la figure 4 est une vue de l'évolution de la vitesse de phase des ondes de volume d'un cristal de niobate de lithium en fonction de l'angle de coupe $\theta 1$, cette famille d'orientations cristallines étant généralement appelée « coupes à simple rotation».
- la figure 5 est une vue de l'évolution des coefficients de couplage de ces mêmes ondes pour le niobate de lithium en fonction de l'angle $\theta 1$,
- la figure 6 est une représentation planaire liée à la plaque du transducteur de la polarisation des ondes de cisaillement,
- la figure 7 est une vue de la représentation du deuxième angle de coupe $\theta 2$ du cristal formant le substrat acoustique,
- la figure 8 est une représentation planaire liée à la plaque du substrat acoustique de la polarisation des ondes de cisaillement du substrat acoustique,
- la figure 9 est un graphique de variation des coefficients de température de la fréquence pour les modes de cisaillement du quartz en fonction de l'angle de coupe $\theta 2$.
- la figure 10 est un graphique de performance typique de stabilité en température dans la bande passante du résonateur de la figure 1 selon l'invention,
- la figure 11 est un ordinogramme d'un mode de mise en oeuvre du procédé de fabrication du résonateur décrit à la figure 2,

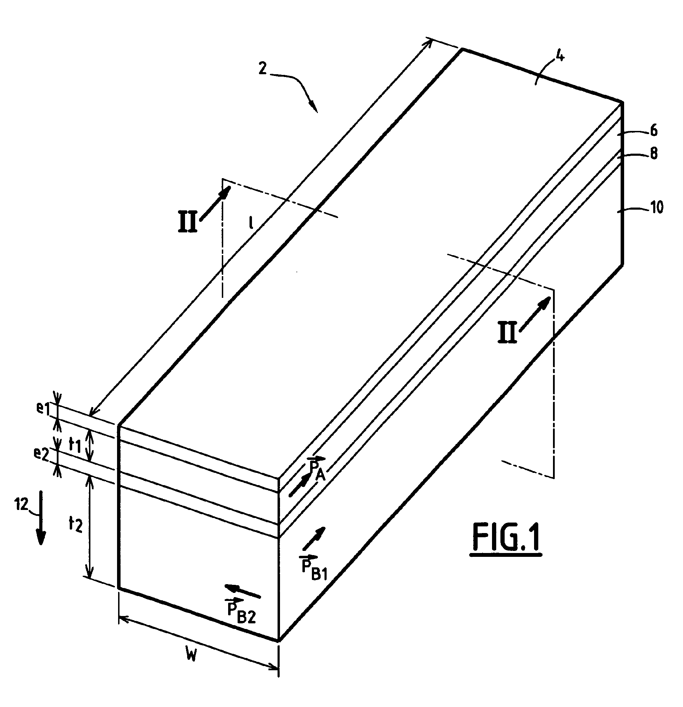

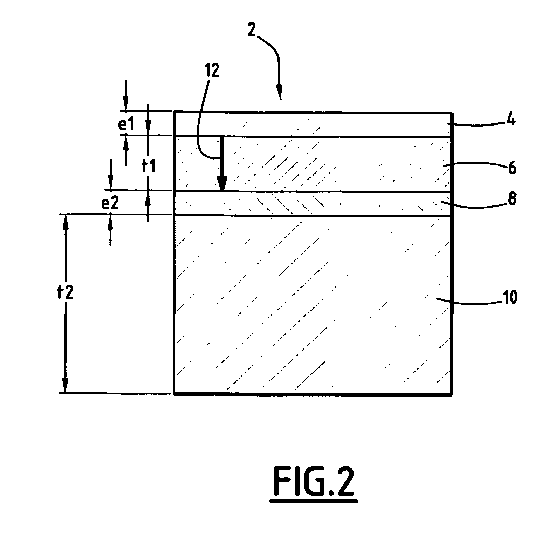

Les figures 1 et 2 représentent un mode de réalisation d'un résonateur 2 de type à ondes de volume à harmoniques élevées selon l'invention.

Le résonateur 2 comprend un empilement de couches successives comportant :

- une électrode supérieure 4 en aluminium d'épaisseur $e_1$,
- un transducteur piézoélectrique 6 constitué d'un premier matériau, ici du niobate de lithium (LiNb03), sous forme monocristalline ayant une première épaisseur $t_1$,
- une contre-électrode 8 en or, enterrée, d'épaisseur $e_2$,
- un substrat acoustique 10 constitué d'un deuxième matériau, ici du quartz, sous forme monocristalline ayant une deuxième épaisseur $t_2$.

Toutes les couches 4, 6, 8 et 10 présentent sur la figure 1 la même longueur L et la même largeur W, la longueur étant nettement supérieure à la largeur W et aux différentes épaisseurs de couche $e_1$, $t_1$, $e_2$ et $t_2$.

Pour simplifier la figure 1, les électrodes 4, 8 sont représentées de surfaces égales à celles du transducteur piézoélectrique 6.

En pratique, les électrodes 4, 8 présentent des surfaces inférieures à celles de la couche piézoélectrique 6, et l'électrode supérieure 4 présente une surface inférieure ou égale à celle de contre-électrode 8 enterrée.

Dans le procédé de fabrication incluant une couche enterrée servant de couche de collage, la contre-électrode 8 présente naturellement une surface supérieure à celle de l'électrode supérieure 4 fabriquée par une technique de lithographie et dépôt de couche métallique.

Les surfaces des électrodes 4, 8 sont disposés en vis à vis, parallèles entre elles, les zones respectives en regard des surfaces étant maximales, avec des bords le plus parallèles possible. Dans le cas idéal, les surfaces des électrodes 4, 8 sont superposées parfaitement.

Ainsi, l'excitation des ondes est supposée correspondre à une configuration de résonateur dit plan-plan, pour laquelle les ondes sont excitées par les électrodes 4, 8 très minces déposées sur les surfaces en regard du transducteur piézoélectrique 6, dans le sens représenté par la flèche 12 selon la figure 2 de propagation des ondes de cisaillement dans le transducteur 6.

Le transducteur piézoélectrique 6 présente un mode de cisaillement excité selon une polarisation dirigée le long de la longueur I du résonateur représenté par le vecteur $\overline{P}_A$.

Le substrat acoustique 10 présente deux modes de cisaillement, un premier dit lent et un deuxième dit rapide.

Les ondes de cisaillement dites rapides et les ondes de cisaillement dites lentes sont définies comme des ondes de cisaillement de polarisation orthogonale, les ondes dites rapides ayant une vitesse de phase supérieure aux ondes dites lentes.

Sur la figure 1, le vecteur de polarisation $\overline{P}_{A1}$ de l'excitation correspondant au mode de cisaillement du transducteur 6 est aligné avec un vecteur de polarisation référencé $\overline{P}_{B1}$ correspondant au mode de cisaillement lent du substrat acoustique.

Un vecteur de polarisation correspondant à l'excitation du mode de cisaillement rapide est représenté sur la figure 1 par $\overline{P}_{B2}$ orthogonal à $\overline{P}_{B1}$ et contenu dans un plan d'extension du substrat 10.

La contre-électrode 8 interposée entre le transducteur 6 et le substrat 10 sert en outre de colle à la structure du résonateur 2.

La couche de niobate de lithium (LiNb03) constituant le transducteur 6 est une plaque découpée selon un premier angle de coupe $\theta 1$ dans un matériau brut monocristallin formant une tranche dénommée wafer en anglais.

La couche de quartz constituant le substrat acoustique 10 est une plaque découpée selon un deuxième angle de coupe $\theta 2$ dans une tranche de quartz monocristallin brut.

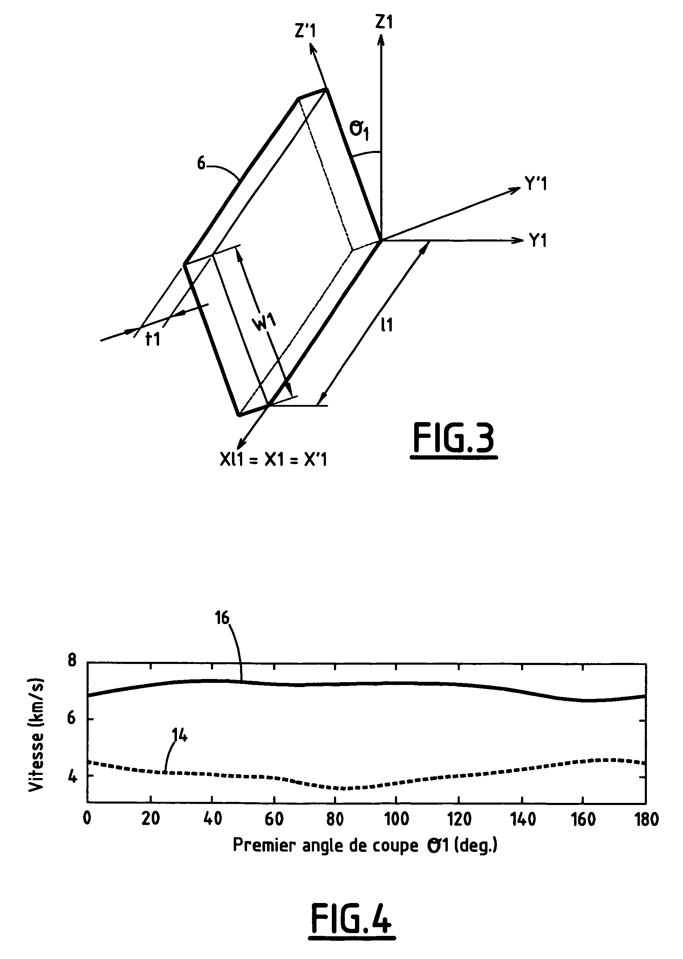

Selon la figure 3, la plaque de niobate de lithium 6 est découpée selon un premier angle $\theta 1$ de coupe à partir du matériau de la tranche non représentée mais repérée par ses axes cristallographiques $X_1$, $Y_1$, $Z_1$, l'axe $Z_1$ étant l'axe longitudinal de la tranche et les axes cristallographiques $X_1$, $Y_1$ étant prédéterminés lors de la fabrication du monocristal.

L'angle $\theta 1$ est ici celui défini dans le standard IEEE Std-176 (révision 1949) comme l'angle $\theta 1$ d'une coupe à simple rotation autour de l'axe cristallographique X1, la coupe étant notée $(Y_1 \, X_{l1},) \, / \, \theta 1$ dans le standard IEEE, $X_{l1}$ étant l'axe aligné sur le bord inférieur droit d'épaisseur $t_1$ de longueur l1 selon la représentation de la figure 3.

Le repère lié à la plaque découpée 6 est représenté par les trois axes $X'_1$, $Y'_1$, $Z'_1$, l'axe $X'_1$ étant confondu avec l'axe $X_1$. Les deux axes $Y'_1$, $Z'_1$, sont obtenus respectivement par la rotation d'angle $\theta 1$ des axes $X_1$, $Y_1$ autour de l'axe $X_1$.

La figure 4 représente l'évolution de la vitesse de phase des ondes longitudinales et de cisaillement pour des coupes à simple rotation autour de l'axe cristallographique $X_{l1}$ du transducteur 6.

La courbe 14 représente la vitesse de phase des ondes de cisaillement se propageant dans le transducteur 6 selon l'axe normal aux plans des électrodes 4 et 8, en fonction du premier angle de coupe $\theta 1$ exprimé en degrés.

La courbe 16 représente la vitesse de phase des ondes longitudinales, exprimée en km/s, se propageant dans le transducteur 6 selon l'axe de la longueur l en fonction du premier angle $\theta 1$, exprimé en degrés.

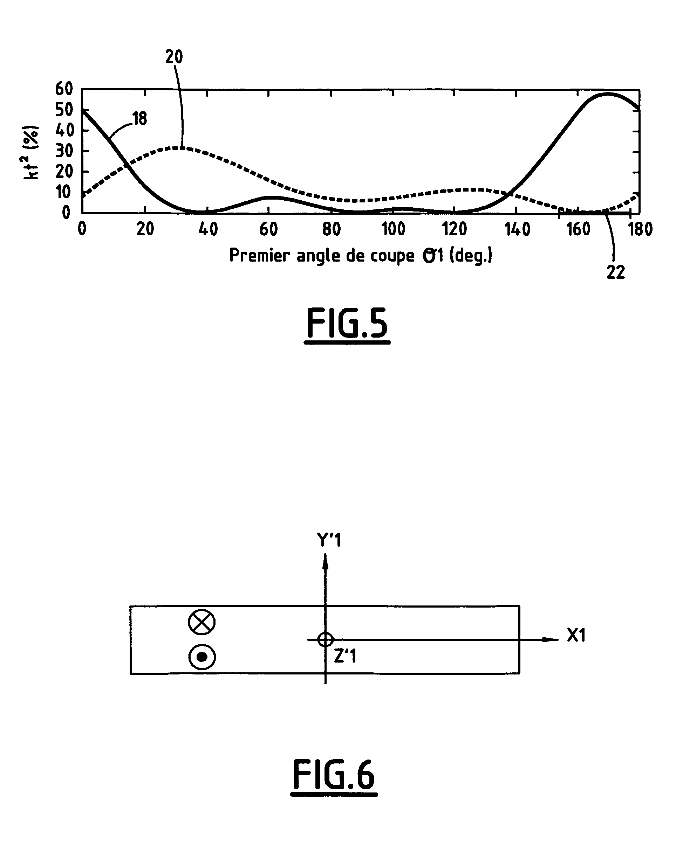

La figure 5 représente le couplage des ondes longitudinales et de cisaillement pour les coupes à simple rotation autour de l'axe cristallographique $X_1$ du transducteur 6.

La courbe 18 représente l'évolution du coefficient de couplage $K^2_T$ exprimée en pourcentage d'énergie électrique convertie en énergie acoustique pour des ondes de cisaillement en fonction du premier angle de coupe $\theta 1$ exprimé en degrés.

La courbe 20 représente l'évolution du coefficient de couplage $K^2_T$ exprimée en pourcentage d'énergie électrique convertie en énergie acoustique pour des ondes longitudinales en fonction du premier angle de couple $\theta 1$ exprimé en degrés.

Il est visible sur la figure 5 que les courbes 18 et 20 présentent une zone angulaire 22 dans laquelle l'onde longitudinale n'est quasiment pas couplée par piézoélectricité et par conséquent non excitée électriquement. L'excitation de l'onde de cisaillement est particulièrement efficace, avec un couplage électromécanique représenté par $K^2_T$ compris entre 50 et 60%.

La zone angulaire 22 est centrée autour de l'angle $\theta 1$ égal à 163° et d'amplitude égale à 10°.

L'angle de couple $\theta 1$ du transducteur décrit à la figure 1 est choisi dans la zone 22 de la figure 6 égal à 163°.

Pour les coupes de niobate de lithium à simple rotation, seul le mode correspondant à l'onde de cisaillement rapide présente un couplage électromécanique par piézoélectricité. En considérant la représentation planaire fournie à la figure 6 de la plaque du transducteur 6 selon les axes planaires $X'_1$, $Y'_1$ , on montre que le mode de cisaillement excité par piézoélectricité présente une polarisation scalaire selon l'axe $Z'_1$ représenté de bout sur la figure 6, c'est à dire normal au plan $(X'_1, Y'_1)$, mais dont la dépendance spatiale est décrite par une fonction des coordonnées spatiales selon le plan d'excitation. Le vecteur de polarisation $\overline{P}_A$ est colinéaire à l'axe $Z'_1$.

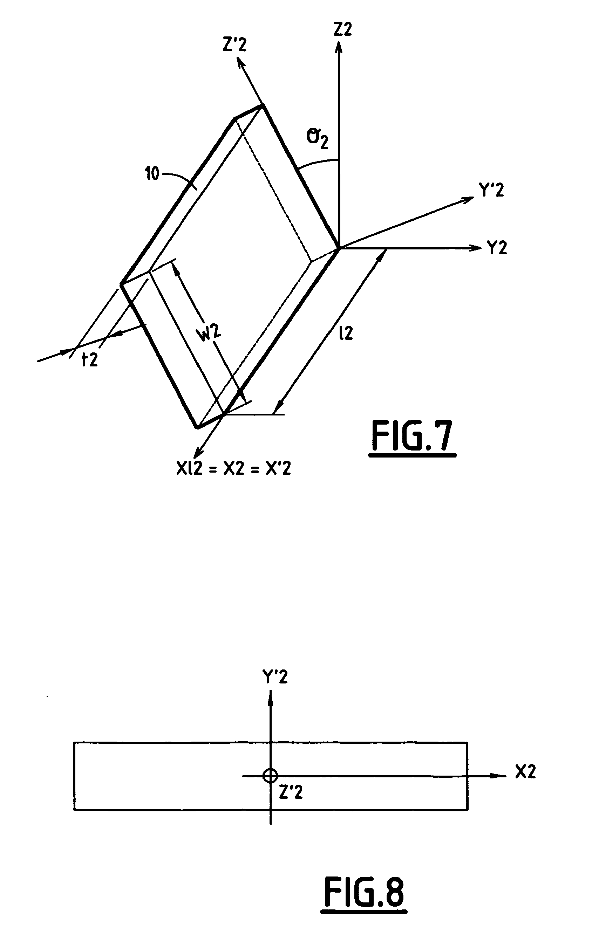

Selon la figure 7, la plaque de quartz 10 est découpée selon un deuxième angle $\theta 2$ de coupe à partir du monocristal brut de la tranche non représentée mais repérée par les axes cristallographiques du quartz $X_2$, $Y_2$, $Z_2$, l'axe $Z_2$ étant l'axe optique C révélé lors de la croissance d'une gemme de cristal.

L'angle $\theta 2$ est également ici celui défini dans le standard IEEE Std-176 (révision 1949) comme l'angle $\theta 2$ d'une coupe à simple rotation autour de l'axe cristallographique $X_2$, la coupe étant notée $(Y_2, X_{l2}) \, / \, \theta 2$ dans le standard IEEE Std-176, $X_{l2}$ étant l'axe aligné sur le bord inférieur droit d'épaisseur $t_2$ de longueur $L_2$ selon la représentation de la figure 4.

Le repère lié à la plaque de quartz découpée 10 est représenté par les trois axes $X'_2$, $Y'_2$, $Z'_2$, l'axe $X'_2$ étant confondu avec l'axe $X_2$. Les deux axes $Y'_2$, $Z'_2$ sont obtenus respectivement par la rotation d'angle $\theta 2$ des axes $Y_2$, $Z_2$ autour de l'axe $X_2$.

En considérant la représentation planaire selon les axes $X'_2$, $Y'_2$ fournie à la figure 8 de la plaque de quartz 10, analogue à la représentation planaire fournie pour le transducteur 6 à la figure 6, on peut décrire la polarisation du mode de cisaillement que l'on cherche à exploiter dans le quartz qui présente des coupes pour lesquelles les sensibilités en température du premier ordre sont proches de zéro sans changer de signe. Le cisaillement du quartz est également scalaire mais s'établit selon l'axe $X'_2$ et dépend des coordonnées locales liées à la plaque selon le plan d'excitation. Pour les plaques de niobate ou de tantalate de lithium à simple de rotation notée $(YXl/\theta)$ selon la notation standard IEEE révision 1949 (IEEE standard on piezoelectricity Std 176-1949, Proc. of the IRE, vol. 37, pages 1378-1395, 1949), les ondes de cisaillement choisies présentent donc des polarisations orthogonales entre elles et ne se couplent que si les alignements des axes cristallographiques du transducteur 6 et du substrat acoustique sont convenablement choisis. Il faut tenir compte de ces polarisations lors de l'assemblage des matériaux du transducteur et du substrat acoustique pour permettre le couplage des ondes acoustiques que l'on veut exciter dans le substrat acoustique 10 de propagation, ici le quartz.

Ici, cet effet de couplage acoustique est obtenu en alignant l'axe $Z'_1$ du transducteur 6 sur l'axe $X'_2$ du substrat acoustique 10, ou de manière équivalente en alignant l'axe $X'_1$ du transducteur 6 sur l'axe $Z'_2$ du substrat acoustique 10, de sorte que la polarisation $\overline{P}_A$ soit identique à celles de modes de cisaillement dans la substrat acoustique 10 représenté par $\overline{P}_{B1}$ permettant la compensation de la dérive thermique de la vitesse de phase des ondes correspondantes.

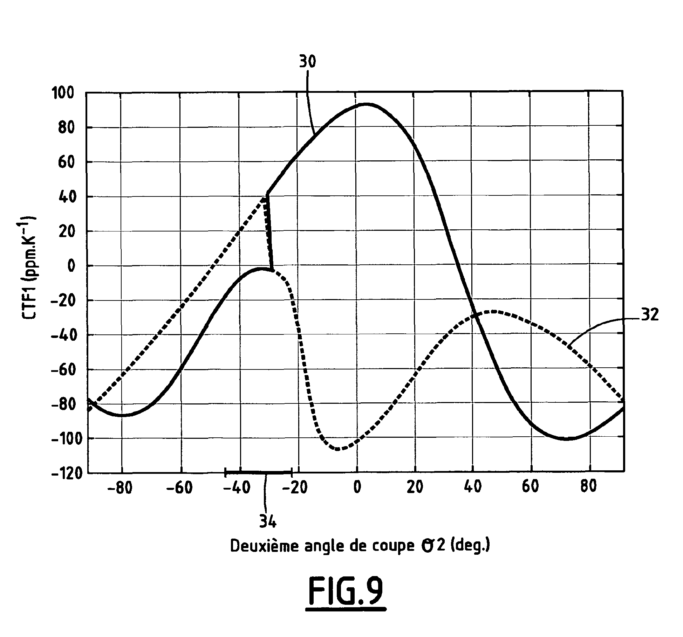

La figure 9 représente la sensibilité des modes de cisaillement du quartz aux effets thermiques statiques sous forme de deux coefficients de température de la fréquence du premier ordre CTFB1 et CTFB2 pour un substrat acoustique 10 plan-plan similaire à celui de la figure 1 exprimée en ppm.K$^{-1}$ (partie par millions de la fréquence par Kelvin), en fonction du deuxième angle de couple θ2 exprimé en degrés.

Une première courbe 30 en trait plein représente l'évolution d'un premier coefficient de température de la fréquence du premier ordre CTFB1 pour les ondes de cisaillement couplées par piézoélectricité dites lentes en fonction du deuxième angle de coupe θ2, leur polarisation correspondant au vecteur $\overline{P}_{B1}$ orienté selon l'axe X'$_2$ lorsque la valeur du deuxième angle de coupe θ2 est comprise entre -90 et -24 degrés, et orienté selon l'axe Z'$_2$ lorsque θ2 est compris entre -24 et +90 degrés.

Une deuxième courbe 32 en trait pointillé représente l'évolution d'un deuxième coefficient de température de la fréquence du premier ordre CTFB2 pour les ondes de cisaillement non couplées par piézoélectricité dites rapides en fonction du deuxième angle de coupe θ2, leur polarisation correspondant au vecteur $\overline{P}_{B2}$ orienté selon l'axe Z'$_2$ lorsque la valeur du deuxième angle de coupe θ2 est comprise entre -90 et -24 degrés, et orienté selon l'axe X'$_2$ lorsque θ2 est compris entre -24 et +90 degrés.

Les ondes de cisaillement dites rapides ou de mode rapide et les ondes de cisaillement dites lentes ou de mode lent sont définies comme des ondes de cisaillement de polarisation orthogonale, les ondes dites rapides ayant une vitesse de phase supérieure aux ondes dites lentes.

Dans le cas du quartz, au voisinage de l'angle de coupe θ2 égal à -24 degrés, les deux modes lent et rapide échangent leur polarisation. Les modes restent orthogonaux mais le mode de cisaillement rapide se substitue au mode de cisaillement lent pour les coupes d'angle θ2 compris entre -24 et -90 degrés. Ce phénomène est visible sur la figure 9 où les coefficients des deux modes évoluent de façon abrupte au voisinage de θ2 égal à -24 degrés.

Cela a pour conséquence que la représentation de la figure 1 correspond à un angle de coupe θ2 inférieur à -24 degrés, et la polarisation de vecteur $\overline{P}_{B1}$ correspond à un cisaillement lent d'axe X$_2$.

Dans le cas où l'angle de coupe θ2 est supérieur à -24 degrés, les vecteurs de polarisation $\overline{P}_{B1}$ et $\overline{P}_{B2}$ de la figure 1 sont permutés et il convient de faire tourner de 90 degrés la plaque du transducteur, c'est-à-dire le vecteur de polarisation $\overline{P}_A$ de l'onde d'excitation du transducteur, de façon à aligner les vecteur $\overline{P}_A$ sur le vecteur de polarisation $\overline{P}_{B1}$ de cisaillement lent, si on veut travailler à mode de cisaillement constant.

La courbe 30 montre l'existence d'une zone angulaire 34 dans laquelle le premier coefficient de température de la fréquence du premier ordre CTFB1 pour les ondes de cisaillement lentes est proche de zéro et s'en approche de manière douce. La zone angulaire 34 est centrée autour de -35 degrés et présente une amplitude de 22 degrés garantissant ainsi un premier coefficient de température de la fréquence du premier ordre CTFB1 inférieur en valeur absolue à 20 ppm.K$^{-1}$.

Le premier angle de coupe l'angle θ1 du transducteur de la figure 1 est choisi dans la zone 22 et le deuxième angle θ2 du substrat acoustique est choisi dans la zone 34.

Ainsi, une structure de résonateur HBAR peut être constituée dans laquelle les dimensions géométriques du transducteur sont définies de telle façon que le résonateur résonne à une fréquence d'accord souhaitée avec des caractéristiques électriques supplémentaires résultant d'exigences de fonctionnement d'une application.

Les caractéristiques électriques supplémentaires sont par exemple la séparation spectrale entre deux modes de résonance définie comme la zone spectrale autour du mode de résonance dépourvue d'autres résonances, l'efficacité de couplage électromécanique du mode de résonance sélectionné, l'impédance caractéristique à la résonance, le coefficient de qualité à la résonance et la stabilité thermique du mode de résonance.

La séparation spectrale permet de définir l'épaisseur totale de l'empilement des couches du résonateur HBAR puisque la séparation spectrale correspond à la fréquence du mode fondamental de l'ensemble formé par le transducteur et le substrat acoustique incluant l'électrode enterrée.

Les épaisseurs de chaque couche du résonateur HBAR formée de matériaux différents sont ajustées de sorte à obtenir un mode à la fréquence de résonance ou d'accord souhaitée.

L'épaisseur du transducteur piézoélectrique est déterminée également en tenant compte du couplage électromécanique souhaité. Le couplage est maximum lorsque le mode sélectionné est proche du mode fondamental de la résonance dans transducteur piézoélectrique seul.

Le rapport des épaisseurs transducteur/substrat acoustique est ajusté en fonction de la stabilité thermique recherchée et du coefficient de qualité de la résonance visée, sachant que pour atteindre de manière fiable la performance du paramètre de qualité à la résonance, il est nécessaire de bien connaître les constantes viscoélastiques des matériaux utilisés ou d'autres coefficients physiques à valeurs complexes représentatifs de propriétés physiques comme par exemple les constantes diélectriques. Les parties imaginaires de ces constantes sont souvent déterminées de façon heuristique ou par ajustement de paramètres de modèles prédictifs.

L'impédance à la résonance dépend du couplage électromécanique du mode sélectionné et de la valeur des surfaces d'électrodes en regard. Pour une impédance donnée par exemple 50 ohms, les surfaces en regard des électrodes seront d'autant plus grandes que le couplage électromécanique du mode sélectionné est faible.

Les surfaces d'électrodes typiques sont comprises entre quelques centaines de μm$^2$ et quelques mm$^2$

pour des épaisseurs d'empilement allant du mm à quelques µm.

Le couplage des vibrations électroacoustiques du transducteur 6 sur celles de mode rapide du substrat acoustique 10 est effectué au travers de la contre-électrode 8 qui agit comme un court circuit acoustique dans la bande passante du transducteur 6.

Le substrat acoustique 10 asservit ainsi les modes de résonance du transducteur 6 sur ses propres modes de résonance et confère par là-même une forte stabilité en température aux modes de résonance du transducteur 6 qui laissés libres dériveraient fortement. En effet, les coefficients de température de la fréquence du premier ordre des transducteurs piézoélectriques HBAR présentent des valeurs élevées, supérieures à 80 ppm.K$^{-1}$ pour le niobate de lithium et à 40 ppm.K$^{-1}$ pour le tantalate de lithium en valeurs absolues.

La stabilité en température des modes de résonance du transducteur 6 ainsi asservis est celle correspondant à la valeur du coefficient en température de fréquence CTFB1 sélectionnée au travers du deuxième angle de coupe θ2 et de l'alignement des vecteurs de polarisation $\overline{P}_A$, $\overline{P}_{B1}$ correspondant respectivement au mode de cisaillement du transducteur 6 et au mode de cisaillement lent du quartz 10 pour des rapports d'épaisseurs Re des milieux de transduction et de propagation acoustique inférieurs à 5%, par exemple un rapport de 2,5 µm de niobate de lithium sur 50 µm de quartz, et des modes de la structure du résonateur HBAR ne correspondant ni au fondamental, ni aux harmoniques impaires de la résonance de la couche de transduction seule.

Dans la configuration décrite ci-dessus, en première approximation la valeur du coefficient en température de fréquence du premier ordre du résonateur HBAR la plus faible atteignable est égale à -2 ppm.K$^{-1}$ . Elle correspond à une coupe de quartz (Y$_2$, X$_{l2}$) / -32°ou +/-5°autour de -32°. La précision de la valeur calculée atteignable est égale à +/- 2 ppm.K$^{-1}$ compte tenu de l'incertitude des constantes physiques utilisées pour le calcul du dimensionnement du résonateur HBAR.

De manière plus précise, la valeur approximative du coefficient en température de fréquence du premier ordre du résonateur HBAR la plus faible atteignable doit être corrigée par un terme correctif additionnel qui représente la contribution de la zone de transduction et dépend de l'ordre du mode de résonance et du rapport des épaisseurs transducteur/substrat acoustique. Ce terme correctif s'écrit α.n avec n le nombre entier désignant l'ordre du mode de résonance et un coefficient α dépendant du rapport des épaisseurs Re égal respectivement à -3.10$^{-7}$, - 1,5. 10$^{-7}$, -3, 75.10$^{-8}$, -1,875.10$^{-8}$ pour un rapport des épaisseurs Re égal à 5%, 2%, 1%, 0,5%. Une fois atteint le mode de résonance correspondant à l'optimum de couplage (une demi-longueur d'onde dans la couche de transduction), cette loi de variation du terme correctif n'est pas valide.

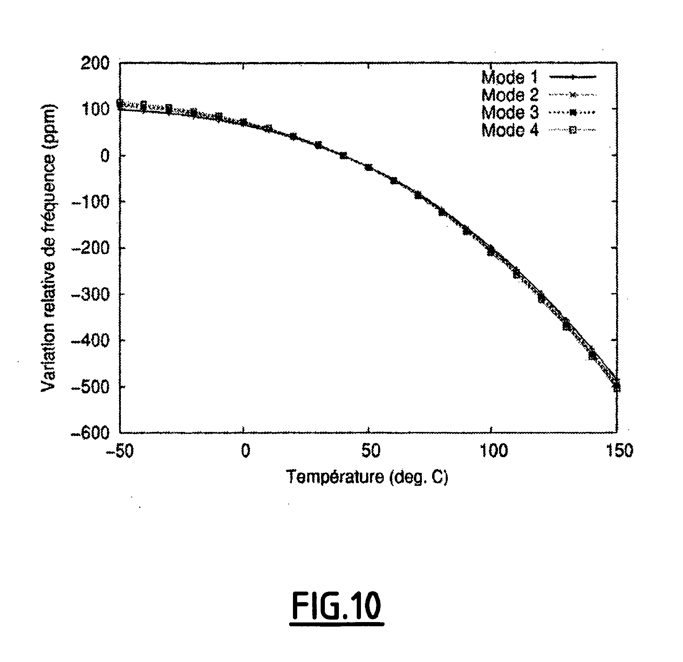

La figure 10 représente les performances de stabilité en température d'un résonateur HBAR selon l'invention.

Cette figure illustre la notion de température d'inversion Tinv du coefficient en température de fréquence du premier ordre d'un résonateur, ici de type HBAR. La température d'inversion Tinv est la température à laquelle le premier coefficient de température de la fréquence du premier ordre s'annule et change de signe.

La figure 10 représente pour quatre ordres harmoniques de modes de résonance, l'évolution de la variation relative de fréquence exprimée en ppm (partie par million) en fonction de la température d'un résonateur HBAR formé d'un transducteur en niobate de lithium d'angle de coupe θ1 égal à +163 degrés et d'épaisseur 1 µm et d'un substrat acoustique en quartz d'angle de coupe θ2 égal à -32 degrés et d'épaisseur 50 µm.

L'évolution est sensiblement identique pour les quatre ordres de résonance et la dérivée de la courbe d'évolution correspondant au coefficient de température de la fréquence du premier ordre du résonateur s'annule pour une température Tinv égale à -50 °C. En pratique, le coefficient en température de fréquence du premier ordre du résonateur HBAR à base de niobate de lithium sur du quartz est égal à -2 ppm.K-1 pour une température d'inversion d'environ -50 °C.

Le coefficient de température de la fréquence du deuxième ordre du résonateur est ici égal à -16 ppb.K$^{-2}$ et est obtenu à partir de la formule classique :

$$T_{inv} = T_{ref} - \frac{CTF1}{2*CTF2}$$

où

$T_{inv}$ désigne la température d'inversion,
T$_{ref}$ désigne la température de référence, ici égale à +50 °C d'après la figure 10,
CTF1 désigne le coefficient de température de la fréquence du premier ordre du résonateur,
CTF2 désigne le coefficient de température de la fréquence du deuxième ordre du résonateur HBAR.

La valeur du CTF2 du résonateur HBAR obtenue est faible comparée aux effets du second ordre habituellement mesurés sur du quartz seul pour une coupe compensée des effets thermiques du premier ordre, généralement supérieure à 16 ppb.K$^{-2}$ .

La température de fonctionnement nominal du résonateur HBAR est réglable sans difficulté dans la gamme de températures allant de -50°C à -273°C.

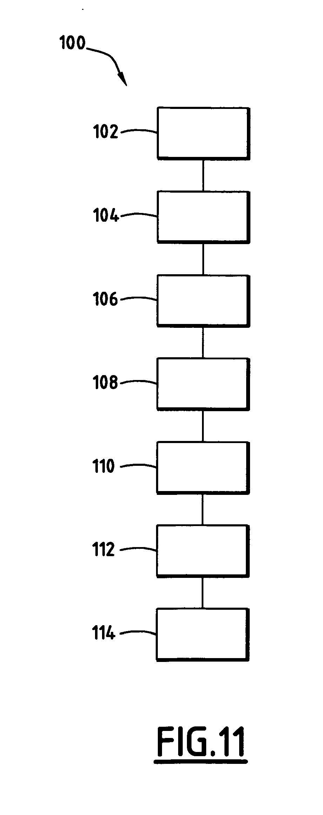

La figure 11 représente un ordinogramme d'un procédé de fabrication 100 d'un résonateur 2 de la figure 1 selon l'invention.

Dans une première étape 102, il est fourni un transducteur piézoélectrique 6 constitué par une couche d'une première épaisseur d'un premier matériau orienté

selon un angle φ défini par la nomenclature (YXw)/φ du standard IEEE Std-176 (révision 1949) égal à zéro et coupé selon un premier angle de coupe θ1 défini par la nomenclature (YXl)/θ du standard IEEE Std-176 (révision 1949), tel que le couplage électroacoustique des ondes de cisaillement est supérieur à 5%, le transducteur 6 ayant un coefficient de température de la fréquence CTFA fonction du premier angle de coupe θ1.

Le matériau du transducteur 6 est compris dans l'ensemble des matériaux constitué par le nitrure d'aluminium (AlN), l'oxyde de zinc (ZnO), le niobate de lithium (LiNbO$_3$), le tantalate de lithium (LiTaO$_3$) et le niobate de potassium.

De préférence, un matériau parmi le niobate de lithium (LiNb03) et le tantalate de lithium (LiTaO$_3$) sera choisi en raison d'une maîtrise plus facile du processus de fabrication d'un monocristal d'une épaisseur significative.

Les niobate et tantalate de lithium peuvent être fabriqués par tranche de diamètre 4" selon des standards d'épaisseur de 500 μm et 350 μm.

Dans une deuxième étape 104, il est fourni un substrat acoustique 10 constitué par une couche d'une deuxième épaisseur d'un deuxième matériau ayant un produit coefficient de qualité acoustique fréquence de travail au moins égal à $5.10^{12}$, orienté selon un angle φ défini par la nomenclature (YXw)/φ du standard IEEE Std-176 (révision 1949) égal à zéro, coupé selon un deuxième angle coupe θ2 défini par la nomenclature (YXl)/θ du standard IEEE Std-176 (révision 1949), présentant une direction de polarisation $\overline{P}_{B1}$ correspondant à un premier mode de vibration de cisaillement, le substrat acoustique 10 ayant un coefficient de température de la fréquence du premier ordre CTFB1 correspondant à l'au moins un mode de cisaillement et dépendant du deuxième angle de coupe θ2,

Dans l'étape 104 de fourniture du substrat 10, le deuxième angle de coupe θ2 du substrat 10 est choisi tel que le coefficient de température de la fréquence du premier ordre CTFB1 correspondant est un extremum local en valeur absolue inférieur à 20 ppm.K$^{-1}$ et la variation de CTFB1 autour de cette valeur de θ2 est une variation douce inférieure en valeur absolue à 2 ppm.K$^{-1}$/degré.

Le matériau du substrat acoustique est compris dans l'ensemble des matériaux constitué par le quartz et substituts isomorphes de type par exemple le GeO$_2$ et le TeO$_2$, l'orthophosphate de gallium (GaPO$_4$) également de structure isomorphe, le niobate de potassium, le tétraborate de lithium (LiB4O$_7$) la langasite (La$_3$Ga$_5$SiO$_{14}$), le langatate, la langanite et leurs différentes variantes.

De préférence, le matériau du substrat acoustique est du quartz en raison de ses remarquables propriétés de stabilité en température et de sa parfaite connaissance dans le domaine de la cristallographie.

Dans une étape suivante 106, une face du transducteur 6 et une face du substrat acoustique 10 sont métallisées selon une épaisseur comprise entre 100 à 200 nm par un métal thermo-compressible ou compressible à froid, par exemple de l'or, du cuivre ou de l'indium, en vue de coller les deux faces et de former ainsi une contre-électrode.

L'or est un matériau particulièrement propice à ce genre de collage, compte tenu des ses propriétés plastiques et de sa robustesse mécanique suffisante pour assurer une liaison acoustique entre le transducteur 6 et le substrat acoustique 10.

A l'étape 108 d'assemblage, le transducteur 6 et le substrat acoustique 10 sont disposés de telle sorte que la direction de polarisation $\overline{P}_A$ du mode de cisaillement du transducteur 6 et la direction de polarisation $\overline{P}_{B1}$ de l'au moins un mode de cisaillement du substrat 10 correspondant au deuxième angle θ2 de coupe sont alignées.

Dans une étape suivante 110, le collage est effectué par compression avec élévation de température ou non selon le métal utilisé.

Dans le cas de l'utilisation de l'or, la phase de chauffage est éliminée et un pressage de longue durée est mis en oeuvre mettant à profit les qualités de surface en regard et la ductilité du matériau métallique pour assurer le collage.

Ainsi, plusieurs plaquettes composites niobate de lithium/ quartz ont pu être réalisées de cette manière sans défaut en se contentant de maintenir une température de 30° C durant les 16 heures d'application d'une pression de 3000 Newtons.

Ensuite dans une étape 112, la plaquette du résonateur est rodée et polie.

Puis dans une étape 114, une électrode est métallisée sur une face du transducteur 6 opposée au substrat.

Le procédé est simple à mettre en oeuvre en particulier grâce à une large plage de valeurs du deuxième angle de coupe θ2 permettant d'obtenir de bonnes performances de stabilité en température.

En outre, les résonateurs obtenus par ce procédé peuvent fonctionner jusqu'à des fréquences de 20 GHz. Les résonateurs sont légers et peu encombrants, offrant un niveau d'intégration élevée.

Un tel résonateur peut par exemple être intégré dans un oscillateur homodyne ou dans des cellules d'un filtre à réjection élevé.

Bien entendu d'autres applications peuvent être envisagées.

## Revendications

1. Résonateur de type à ondes de volumes à modes harmoniques élevés HBAR destiné à travailler à une fréquence de travail prédéterminée comprenant :

    un transducteur piézoélectrique (6) constitué par une couche d'une première épaisseur d'un premier matériau orienté selon un angle $\varphi$ défini par la nomenclature (YXw)/$\varphi$ du standard IEEE Std-176 (révision 1949) égal à zéro, coupé selon un premier angle de coupe $\theta 1$ défini par la nomenclature (YXl)/$\theta$ du standard IEEE Std-176 (révision 1949), tel que le couplage électroacoustique des ondes de cisaillement au sein de ce matériau seul est supérieur à 5%, le transducteur (6) ayant un coefficient de température de la fréquence CTFA fonction du premier angle de coupe $\theta 1$,

un substrat acoustique (10) constitué par une couche d'une deuxième épaisseur d'un deuxième matériau ayant un produit coefficient de qualité acoustique fréquence de travail au moins égal à $5.10^{12}$ , orienté selon un angle $\varphi$ défini par la nomenclature (YXw)/$\varphi$ du standard IEEE Std-176 (révision 1949) égal à zéro, coupé selon un deuxième angle de coupe $\theta 2$ défini par la nomenclature (YXl)/$\theta$ du standard IEEE Std-176 (révision 1949), présentant au moins une direction de polarisation $\overline{P}_{B_1}$ correspondant à un premier mode de vibration de cisaillement, le substrat acoustique (10) ayant un coefficient de température de la fréquence du premier ordre CTFB1 correspondant à l'au moins un mode de cisaillement et dépendant du deuxième angle de coupe $\theta 2$,

une contre-électrode (8) formé par une couche de métal collant une première face du transducteur (6) et une face du substrat acoustique (10), et

une électrode (4) disposée sur une deuxième face du transducteur (6) opposée à la première face du transducteur (6) et le substrat (10),

**caractérisé en ce que**

la disposition relative du transducteur (6) et du substrat (10) est telle que la direction de polarisation $\overline{P}_A$ du mode de cisaillement du transducteur (6) et la direction de polarisation $\overline{P}_{B_1}$ de l'au moins un mode de cisaillement du substrat (10) correspondant au deuxième angle $\theta 2$ de coupe sont alignées, et

le deuxième angle de coupe $\theta 2$ du substrat (10) est tel que le coefficient de température de la fréquence du premier ordre CTFB1 correspondant est un extrémum local en valeur absolue inférieur à 20 ppm.$K^{-1}$ et la variation de CTFB1 autour de cette valeur de $\theta 2$ est une variation douce inférieure en valeur absolue à 2 ppm.$K^{-1}$/degré.

2. Résonateur de type HBAR selon la revendication 1, **caractérisé en ce que** le coefficient de température de la fréquence du premier ordre CTF1 du résonateur est égal sensiblement au coefficient de température de la fréquence du premier ordre CTFB1 pour des modes de résonateur HBAR ne correspondant ni au fondamental, ni aux harmoniques impaires de la résonance du transducteur seul lorsque le rapport Re de la première épaisseur sur la deuxième épaisseur est inférieur à 5%.

3. Résonateur de type HBAR selon l'une des revendications 1 et 2, **caractérisé en ce que** la valeur du coefficient en température de fréquence du premier ordre CTF1 du résonateur est égale au coefficient de température de la fréquence du premier ordre CTFB1 corrigé par un terme correctif additionnel pour des modes de résonateur HBAR ne correspondant ni au fondamental, ni aux harmoniques impaires de la résonance du transducteur seul lorsque le rapport Re de la première épaisseur sur la deuxième épaisseur est inférieur à 5%, le terme correctif s'écrivant $\alpha.n$ avec n le nombre entier désignant l'ordre harmonique du mode de résonance du résonateur et $\alpha$ un coefficient dépendant du rapport des épaisseurs Re décroissant en valeur absolue en fonction de Re.

4. Résonateur de type HBAR selon l'une des revendications 1 à 3, **caractérisé en ce que** le matériau du transducteur est compris dans l'ensemble des matériaux constitué par le nitrure d'aluminium (AlN), l'oxyde de zinc (ZnO), le niobate de lithium ($LiNbO_3$), le tantalate de lithium ($LiTaO_3$) et le niobate de potassium.

5. Résonateur de type HBAR selon la revendication 4, **caractérisé en ce que** le matériau du transducteur est compris de préférence dans l'ensemble des matériaux constitué par le niobate de lithium ($LiNbO_3$) et le tantalate de lithium ($Li-TaO_3$).

6. Résonateur de type HBAR selon l'une des revendications 1 à 5, **caractérisé en ce que** le matériau du substrat acoustique est compris dans l'ensemble des matériaux constitué par le quartz, le niobate de potassium, l'orthophosphate de gallium ($GaPO_4$), le tétraborate de lithium ($LiB_4O_7$) la langasite ($La_3Ga_5SiO_{14}$), le langatate et la langanite.

7. Résonateur de type HBAR selon la revendication 6, **caractérisé en ce que** le matériau du substrat acoustique (10) est du quartz.

8. Résonateur de type HBAR selon l'une des revendications 1 à 7, **caractérisé en ce que** la contre-électrode est un métal thermo-compressible.

9. Résonateur de type HBAR selon l'une des revendications 1 à 8, **caractérisé en ce que** la contre-électrode est constituée d'or ou de cuivre ou d'indium.

10. Résonateur de type HBAR selon l'une des revendications 1 à 9, **caractérisé en ce que** les dimensions géométriques du résonateur sont adaptées pour une fréquence de résonnance d'une bande de fréquences comprise dans la gamme de fréquences allant de 50 MHz à 20 GHz.

11. Résonateur de type HBAR selon l'une des revendications 1 à 10, **caractérisé en ce que** le matériau du substrat acoustique est du quartz, le deuxième angle de coupe θ2 du substrat (10) est égal à -32 degrés, et la direction de polarisation $\overline{P}_{B1}$ correspond au mode de cisaillement lent du quartz pour la valeur de θ2 égale à -32 degrés.

12. Résonateur de type HBAR selon la revendication 11 et 3, **caractérisé en ce que** le matériau du transducteur est du niobate de potassium et le coefficient α est égal à respectivement -3.10⁻⁷, -1,5. 10⁻⁷, -3, 75.10⁻⁸, -1,875.10⁻⁸ pour un rapport des épaisseurs Re respectif égal à 5%, 2%, 1%, 0,5%.

13. Procédé de fabrication d'un résonateur HBAR comprenant les étapes consistant à :

fournir (102) un transducteur piézoélectrique (6) constitué par une couche d'une première épaisseur d'un premier matériau orienté selon un angle φ défini par la nomenclature (YXw)/φ du standard IEEE Std-176 (révision 1949) égal à zéro, coupé selon un premier angle de coupe θ1 défini par la nomenclature (YXl)/θ du standard IEEE Std-176 (révision 1949), tel que le couplage électroacoustique des ondes de cisaillement au sein de ce matériau seul est supérieur à 5%, le transducteur (6) ayant un coefficient de température de la fréquence CTFA fonction du premier angle de coupe θ1, et
fournir (104) un substrat acoustique constitué par une couche d'une deuxième épaisseur d'un deuxième matériau ayant un produit coefficient de qualité acoustique fréquence de travail au moins égal à 5.10¹² , orienté selon un angle φ défini par la nomenclature (YXw)/φ du standard IEEE Std-176 (révision 1949) égal à zéro, coupé selon un deuxième angle coupe θ2 défini par la nomenclature (YXl)/θ du standard IEEE Std-176 (révision 1949), présentant une direction de polarisation $\overline{P}_{B1}$ correspondant à un premier mode de vibration de cisaillement, le substrat acoustique (10) ayant un coefficient de température de la fréquence du premier ordre CTFB1 correspondant à l'au moins un mode de cisaillement et dépendant du deuxième angle de coupe θ2,
métalliser (106) une face du substrat (10) et une première face du transducteur (6) par un métal thermo-compressible,
assembler (108) le transducteur (6) et le substrat (10),
coller par compression (110) les faces respectives du substrat (10) et du transducteur (6) métallisés à l'étape (106),
métalliser (114) une électrode (4) sur une deuxième face du transducteur (6),
**caractérisé en ce que**
pendant l'étape d'assemblage (108), le transducteur (6) est disposé par rapport au substrat (10) de sorte que la disposition relative du transducteur (6) et du substrat (10) est telle que la direction de polarisation $\overline{P}_A$ du mode de cisaillement du transducteur (6) et la direction de polarisation $\overline{P}_{B1}$ de l'au moins un mode de cisaillement du substrat (10) correspondant au deuxième angle θ2 de coupe sont alignées, et **en ce que** dans l'étape (104) de fourniture du substrat (10), le deuxième angle de coupe θ2 du substrat (10) est choisi tel que le coefficient de température de la fréquence du premier ordre CTFB1 correspondant est un extremum local en valeur absolue inférieur à 20 ppm.K⁻¹ et la variation de CTFB1 autour de cette valeur de θ2 est une variation douce inférieure en valeur absolue à 2 ppm.K⁻¹ /degré.

14. Oscillateur homodyne comprenant un résonateur HBAR défini selon l'une des revendications 1 à 12.

15. Filtre à réjection élevée comprenant des cellules à base de résonateurs HBAR définis selon les revendications 1 à 12.

**Claims**

1. A resonator of the high bulk acoustic resonator type for operating at a predetermined working frequency, comprising:

a piezoelectric transducer (6) formed by a layer with a first thickness of a first material oriented along an angle φ defined by the nomenclature (YXw)/φ of the IEEE Std-176 (1949 revision) standard equal to zero, cut along a first cutting angle θ1 defined by the nomenclature (YXl)/θ of the IEEE Std-176 (1949 revision) standard, such that the electroacoustic coupling of the shear waves within that material alone is greater than 5%, the transducer (6) having a temperature coefficient of the frequency CTFA as a function of the first cutting angle θ1,
an acoustic substrate (10) formed by a second layer with a second thickness of a second material having a working frequency acoustic quality coefficient product at least equal to 5.10¹², oriented along an angle φ defined by the nomenclature (YXw)/φ of the IEEE Std-176 (1949 revision) standard equal to zero, cut along a second cutting angle θ2 defined by the nomenclature (YXI)/θ of the IEEE Std-176 (1949 revision) standard, having at least one polarization direction $\overline{P}_{B1}$ corresponding to a first shearing mode of vibration, the acoustic substrate (10) having a temperature coefficient of the frequency of the first order CTFB1 corresponding to the at least one shearing mode and depending on the second cutting angle θ2,

a counter-electrode (8) formed by a layer of metal adhering to a first face of the transducer (6) and a face of the acoustic substrate (10), and an electrode (4) arranged on a second face of the transducer (6) facing away from the first face of the transducer (6) and the substrate (10),

**characterized in that**

the relative arrangement of the transducer (6) and the substrate (10) is such that the direction of polarization $\overline{P}_{B1}$ of the shearing mode of the transducer (6) and the polarization direction $\overline{P}_A$ of the at least one shearing mode of the substrate (10) corresponding to the second cutting angle θ2 are aligned, and

the second cutting angle θ2 of the substrate (10) is such that the temperature coefficient of the frequency of the corresponding first order CTFB1 is a local extremum with an absolute value of less than 20 ppm.K$^{-1}$ and the variation of CTFB1 around that value of θ2 is slight with an absolute value of less than 2 ppm.K$^{-1}$/degree.

2. The HBAR type resonator according to claim 1, **characterized in that** the temperature coefficient of the frequency of the first order CTF1 of the resonator is substantially equal to the temperature coefficient of the frequency of the first order CTFB1 for HBAR resonator modes not corresponding to the fundamental or the odd harmonics of the resonance of the transducer alone when the ratio Re of the first thickness over the second thickness is less than 5%.

3. The HBAR type resonator according to one of claims 1 and 2, **characterized in that** the value of the temperature coefficient of the frequency of the first order CTF1 of the resonator is equal to the temperature coefficient of the frequency of the first order CTFB1 corrected by an additional corrective term for HBAR resonator modes not corresponding to the fundamental or to the odd harmonics of the resonance of the transducer alone when the ratio Re of the first thickness over the second thickness is less than 5%, the corrective term being written α.n with n the whole number designating the harmonic order of the resonance mode of the resonator and α a coefficient depending on the ratio of the thicknesses Re with decreasing absolute values as a function of Re.

4. The HBAR type resonator according to one of claims 1 to 3, **characterized in that** the material of the transducer is included in the group of materials made up of aluminum nitride (AiN), zinc oxide (ZnO), lithium niobate (LiNbO$_3$), lithium tantalate (LiTaO$_3$) and potassium niobate.

5. The HBAR type resonator according to claim 4, **characterized in that** the material of the transducer is preferably included in the group of materials made up of lithium niobate (LiNbO)$_3$ and lithium tantalate (LiTaO$_3$).

6. The HBAR type resonator according to one of claims 1 to 5, **characterized in that** the material of the acoustic substrate is included in the group of materials made up of quartz, potassium niobate, gallium orthophosphate (GaPO$_4$), lithium tetraborate (LiB$_4$O$_7$), langasite (La$_3$Ga$_5$SiO$_{14}$), langatate and langanite.

7. The HBAR type resonator according to claim 6, **Characterized in that** the material of the acoustic substrate (10) is quartz,

8. The HBAR type resonator according to one of claims 1 to 7, **characterized in that** the counter-electrode is a thermo-compressible metal.

9. The HBAR type resonator according to one of claims 1 to 8, **characterized in that** the counter-electrode is made of gold or copper or indium.

10. The HBAR type resonator according to one of claims 1 to 9, **characterized in that** the geometric dimensions of the resonator are adapted for a resonance frequency of a frequency band included in the frequency range from 50 MHz to 20 GHz.

11. The HBAR type resonator according to one of claims 1 to 10, **characterized in that** the material of the acoustic substrate is quartz, the second cutting angle θ2 of the substrate (10) is equal to -32 degrees, and

the polarization direction $\vec{P}_{B1}$ corresponds to the slow shearing mode of the quartz for a value of θ2 equal to -32 degrees.

12. The HBAR type resonator according to claim 11 and 3, **characterized in that** the material of the transducer of potassium niobate and the coefficient α is equal to -3.10$^{-7}$, -1,5. 10$^{-7}$, -3, 75.10$^{-8}$, -1,875.10$^{-8}$, respectively, for a respective ratio of the thicknesses equal to 5%, 2%, 1%, 0,5%.

13. A method for manufacturing a HBAR resonator comprising the following steps:

providing (102) a piezoelectric transducer (6) made up of a layer of a first thickness of a first material oriented along an angle φ defined by the nomenclature (YXw)/φ of the IEEE Std~176 (1949 revision) standard equal to zero, cut along a first cutting angle θ1 defined by the nomenclature (YXl)/θ of the IEEE Std-176 (1949 revision) standard, such that the electroacoustic coupling of the shear waves within that material alone is greater than 5%, the transducer (6) having a temperature coefficient of the frequency CTFA as a function of the first cutting angle θ1, and providing (104) an acoustic substrate formed by a first layer with a second thickness of a second material having a working frequency acoustic quality coefficient product at least equal to $5.10^{12}$, oriented along an angle φ defined by the nomenclature (YXw)/φ of the IEEE Std-176 (1949 revision) standard equal to zero, cut along a second cutting angle θ2 defined by the nomenclature (YXl)/θ of the IEEE Std-176 (1949 revision) standard, having a polarization direction

$\vec{P}_{B1}$ corrresponding to a first shearing mode of vibration, the acoustic substrate (10) having a temperature coefficient of the frequency of the first order CTFB1 corresponding to the at least one shearing mode and depending on the second cutting angle θ2,

metalizing (106) one face of the substrate (10) and a first face of the transducer (6) using a thermo-compressibte metal,

assembling (108) the transducer (6) and the substrate (10), adhering, by compression (110), the respective faces of the substrate (10) and the transducer (6) metalized in the step (106),

metalizing (114) an electrode (4) on a second face of the transducer (6),

**characterized in that**

during the assembly step (108), the transducer (6) is arranged in relation to the substrate (10) such that the relative arrangement of the transducer (6) and the substrate (10) is such that the polarization direction $\vec{P}_{A}$ of the shearing mode of the transducer (6) and the polarization direction $\vec{P}_{B1}$ of the at least one shearing made of the substrate (10) corresponding to the second cutting angle θ2 are aligned, and

**in that** in the step (104) for providing the substrate (10), the second cutting angle θ2 of the substrate (10) is chosen such that the temperature coefficient of the frequency of the first corresponding order CTFB1 is a local extremum with an absolute value of less than 20 ppm.K$^{-1}$ and the variation of CTFB1 from said value of θ2 is slight with an absolute value of less than 2 ppm.K$^{-1}$ /degree.

**14.** A homodyne oscillator comprising a HBAR resonator defined according to one of claims 1 to 12.

**15.** A high reject filter comprising HBAR resonator-based cells as defined in claims 1 to 12.

**Patentansprüche**

**1.** Volumenwellen-Resonator mit erhöhten harmonischen Moden HBAR, der vorgesehen ist, mit vorgegebener Arbeitsfrequenz zu arbeiten, umfassend:

einen piezoelektrischen Wandler (6), der von einer Schicht einer ersten Dicke eines ersten Materials gebildet wird, das gemäß einem Windel φ, der durch die Nomenklatur (YXw)/φ des Standards IEEE Std-176 (Revision 1949) definiert ist, gleich Null orientiert ist, gemäß einem ersten Schnittwinkel θ1 geschnitten ist, der durch die Nomenklatur (YXw)/θ) des Standards IEEE Std-176 (Revision 1949) definiert ist, derart, dass die elektroakustische Kopplung der Scherwellen in diesem Material allein größer als 5% ist, wobei der Wandler (6) einen Temperaturkoeffizienten der Frequenz CTFA als Funktion des ersten Schnittwinkels θ1 besitzt,

ein akustisches Substrat (10), das von einer Schicht einer zweiten Dicke eines zweiten Materials gebildet wird, das ein Produkt akustischer Gütegrad Arbeitsfrequenz mindestens gleich $5.10^{12}$ aufweist, gemäß einem Windel φ2, der durch die Nomenklatur (YXw)/φ des Standards IE-EE Std-176 (Revision 1949) definiert ist, gleich Null orientiert ist, gemäß einem zweiten Schnittwinkel θ2 geschnitten ist, der durch die Nomenklatur (YXl)/θ) des Standards IEEE Std-176 (Revision 1949) definiert ist, wobei es mindestens eine Polarisationsrichtung $\vec{P}_{B1}$ entsprechend einer ersten Scherschwingungsmode aufweiset, wobei das akustische Substrat (10) einen Temperaturkoeffizienten der Frequenz der ersten Ordnung CTFB1 entsprechend der mindestens einen Schermode hat und vom zweiten Schnittwinkel θ2 abhängt,

eine Gegenelektrode (8), die von einer Metallschicht gebildet wird, die eine erste Fläche des Wandler (6) und eine Fläche des akustischen Substrats (10) verbindet, und

eine Elektrode (4), die auf einer zweiten Fläche des Wandlers (6) entgegengesetzt zur ersten Fläche des Wandlers und zum Substrat (10) angeordnet ist,

**dadurch gekennzeichnet, dass**

die relative Anordnung des Wandlers (6) und des Substrats (10) derart ist, dass die Polarisationsrichtung $\vec{P}_{A}$ der Schermode des Wandlers (6) und die Polarisationsrichtung $\vec{P}_{\beta 1}$ der mindestens einen Schermode des Substrats (10), dem zweiten Schnittwinkel θ2 entsprechend, ausgerichtet sind und

der zweite Schnittwinkel θ2 des Substrats (10) derart ist, dass der korrespondierende Temperaturkoeffizient der Frequenz der ersten Ord-, nung CTFB1 einen lokalen Extremwert bezüglich des Absolutwertes kleiner als 20 ppm.K$^{-1}$ hat und die Änderung des CTFB1 um diesen Wert von θ2 eine mäßige Änderung bezüglich des Absolutwerts kleiner als 2 ppm.K$^{-1}$/Grad ist.

2. HBAR-Resonator nach Anspruch 1, **dadurch gekennzeichnet, dass** der Temperaturkoeffizient der Frequenz erster Ordnung CTF1 des Resonators im Wesentlichen gleich dem Temperaturkoeffizienten der Frequenz der ersten Ordnung CTFB1 für die Moden des Resonators HBAR ist, die weder der Grundmode noch den ungeraden Harmonischen der Resonanz des Resonators allein entsprechen, wenn das Verhältnis Re der ersten Dicke zu der zweiten Dicke kleiner als 5% ist.

3. HBAR-Resonator nach einem der Absprüche 1 und 2, **dadurch gekennzeichnet, dass** der Wert des Temperaturkoeffizienten der Frequenz der ersten Ordnung CTF1 des Resonators gleich dem Temperaturkoeffizienten der Frequenz der ersten Ordnung CTFB1, korrigiert durch einen zusätzlichen Korrekturterm für die Moden des Resonators HBAR ist, die weder der Grundmode noch den ungeraden Harmonischen der Resonanz des Wandlers allein entsprechen, wenn das Verhältnis Re der ersten Dicke zu der zweiten Dicke kleiner als 5% ist, wobei der Korrekturterm sich α.n schreibt, mit n als ganze Zahl, die die Ordnung der Harmonischen der Resonanzmode bezeichnet, und α als Koeffizient, der vom Verhältnis Re der Dicken abhängt, wobei er hinsichtlich des Absolutwertes abhängig von Re abfällt.

4. HBAR-Resonator nach einem der Ansprüche 1 bis 3, dadurch gakennzeichnet, dass das Material des Wandlers ausgewählt ist aus der Gruppe der Materialien, die durch Aluminiumnitrat (AIN), Zinkoxid (2nO), Lithiumniobat (LiNbO$_3$), Lithiumtantalat (LiTaO$_3$) und Kaliumniobat gebildet wird.

5. HBAR-Resonator nach Anspruch 4, dadurch gekennzeiehnet, dass das Material des Wandlers vorzugsweise aus der Gruppe ausgewählt ist, die durch Lithiumniobat (LiNbO$_3$) und Lithiumtantalat (LiTaO$_3$) gebildet wird.

6. HBAR-Resonator nach einem der Ansprüche 1 bis 5, **dadurch gekennzeichnet, dass** das Material des akustischen Substrats aus der Materialgruppe ausgewählt ist, die durch Quarz, Kaliumniobat, Galliumorthophosphat (GaPO$_4$), Lithiumtetraborat (Lib$_4$O$_7$), Lanthangalliumsilikat (La$_3$Ga$_5$SiO$_{14}$), Lanthangalliumtantalat und Lanthangalliumniobium gebildet wird.

7. HBAR-Resonator nach Anspruch 6, **dadurch gekennzeichnet, dass** das Material des akustischen Substrats (10) Quarz ist.

8. HBAR-Resonator nach einem der Ansprüche 1 bis 7, **dadurch gekennzeichnet, dass** die Gegenelektrode ein thermokompressibles Metall ist.

9. HBAR-Resonator nach einem der Ansprüche 1 bis 8, **dadurch gekennzeichnet, dass** die Gegenelektrode aus Gold oder Kupfer oder Indium besteht.

10. HBAR-Resonator nach einem der Absprüche 1 bis 9, **dadurch gekennzeichnet, dass** die geometrischen Abmessungen des Resonators an eine Resonanzfrequenz eines Frequenzbandes angepasst sind, das in der Frequenzskala zwischen 50 MHz und 20 GHz liegt.

11. HBAR-Resonator nach einem der Ansprüche 1 bis 10, **dadurch gekennzeichnet, dass**
das Material des akustischen Substrats Quarz ist, der zweite Schnittwinkel θ2 des Substrats (10) gleich -32 Grad ist, und die Polarisationsrichtung $\vec{P}_{\beta 1}$ der langsamen Schermode für den Wert von θ2 gleich -32 Grad entspricht.

12. HBAR-Resonator nach einem der Ansprüche 1 bis 10, **dadurch gekennzeichnet, dass**
das Material des Wandlers Kaliumniobat ist und α jeweils gleich $-3.10^{-7}$, $-1,5.10^{-7}$, $-3,75.10^{-8}$, $-1,875.10^{-8}$ für ein Verhältnis Re der Dicken jeweils gleich 5%, 2%, 1%, 0,5% ist,

13. Verfahren zur Herstellung eines HBAR-Resonators, das die Schritte umfasst, die darin bestehen:

einen piezoelektrischen Wandler (6) bereitzustellen (102), der von einer Schicht einer ersten Dicke eines ersten Materials gebildet wird, das gemäß einem Winkel φ, der durch die Nomenklatur (YXw)/φ des Standards IEEE Std-176 (Revision 1949) definiert ist, gleich Null orientiert ist, gemäß einem ersten Schnittwinkel θ1 geschnitten ist, der durch die Nomenklatur (YXw) /θ des Standards IEEE Std-176 (Revision 1949) definiert ist, derart, dass die elektroakustische Kopplung der Scherwellen in diesem Material allein größer als 5% ist, wobei der Wandler (6) einen Temperaturkoeffizienten der Frequenz CTFA als Funktion des ersten Schnittwinkels θ1 besitzt" und

ein akustisches Substrat bereitzustellen (104), das von einer Schicht einer zweiten Dicke eines zweiten Materials gebildet wird, das ein Produkt akustischer Gütegrad Arbeitsfrequenz mindestens gleich $5.10^{12}$ aufweist, gemäß einem Wikkel $\varphi 2$, der durch die Nomenklatur (YXw)/$\varphi$ des Standards IEEE Std-176 (Revision 1949) definiert ist, gleich Null orientiert ist, gemäß einem zweiten Schnittwinkel $\theta 2$ geschnitten ist, der durch die Nomenklatur (YXl)/$\theta$ des Standards IEEE Std-176 (Revision 1949) definiert ist, wobei es mindestens eine Polarisationsrichtung $\vec{P}_{\beta i}$ entsprechend einer ersten Scherschwingungsmode aufweist, wobei das akustische Substrat (10) einen Temperaturkoeffizienten der Frequenz der ersten Ordnung CTFB1 entsprechend der mindestens einen Schermode hat und vom zweiten Schnittwinkel $\theta 2$ abhängt, eine Fläche des Substrats (10) und eine erste Fläche des Wandlers (6) mit einem thermokompressiblen Metall zu metallisieren (106), den Wandler (6) und das Substrat (10) zusammenzufügen (108), die jeweiligen Flächen des Substrats (10) und des Wandlers (6), die beim Schritt (106) metallisiert wurden, durch Kompression (110) zu verbinden, eine Elektrode (4) auf eine zweite Fläche des Wandlers (6) zu metallisieren (114), **dadurch gekennzeichnet, dass** während des Schritts des Zusammenfügens (108) der Wandler (6) in Bezug auf das Substrat (10) derart angeordnet wird, dass die relative Anordnung des Wandlers (6) und des Substrats (10) derart ist, dass die Polarisationsrichtung $\vec{P}_{A}$ der Schermode des Wandlers (6) und die Polarisationsrichtung $\vec{P}_{\beta 1}$ der mindestens einen Schermode des Substrats (10), dem zweiten Schnittwinkel $\theta 2$ entsprechend, r ausgerichtet sind, und dass bei dem Schritt (104) des Bereitstellens des Substrats (10) der zweite Schnittwinkel $\theta 2$ des Substrats (10) derart gewählt ist, dass der korrespondierende Temperaturkoeffizient der Frequenz der ersten Ordnung CTFB1 einen lokalen Extremwert bezüglich des Absolutwerts kleiner als 20 ppm.$K^{-1}$ hat und die Änderung von CTFB1 um diesen Wert von $\theta 2$ eine mäßige Änderung bezüglich des Absolutwerts kleiner als 2 ppm.$K^{-1}$/Grad ist.

14. Homodyner Oszillator, einen HBAR-Resonator nach einem der Ansprüche 1 bis 12 umfassend.

15. Filter mit erhöhter Bandsperre, das Zellen auf der Grundlage von HBAR-Resonatoren umfasst, die gemäß den Ansprüchen 1 bis 12 definiert sind.

EP 2 291 911 B1

**FIG.1**

15

**FIG.2**

## FIG.3

## FIG.4

## FIG.5

## FIG.6

FIG.7

FIG.8

FIG.9

**FIG.10**

FIG.11

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- IEEE standard on piezoelectricity Std 176-1949. *Proc. of the IRE,* 1949, vol. 37, 1378-1395